# EUROPEAN PATENT APPLICATION

(11) **EP 4 693 364 A1**
(43) Date of publication of application: **11.02.2026**
(21) Application number: 25194333.8
(22) Date of filing: 06.08.2025
(51) Int. Cl.: H01J 37/32

(54) **SUBSTRATE PROCESSING EQUIPMENT HAVING MEASUREMENT MODULE FOR MEASURING CURRENT, VOLTAGE AND POWER OF OUTPUT POWER**

(30) Priority: 06.08.2024 KR 20240104755
(71) Applicant: Korea Institute of Fusion Energy, Daejeon 34133 (KR)
(72) Inventor: KIM, Jongsik, Gunsan-si, Jeollabuk-do (KR)
(74) Representative: ABG Intellectual Property Law, S.L.

(57) **Abstract**

The present invention relates to a substrate processing equipment, and more particularly, to a substrate processing equipment equipped with a current, voltage and power measurement module for measuring the current/voltage applied for generating and maintaining plasma, and further for measuring the power of incident and reflected waves. The present invention discloses a substrate processing equipment comprising a process chamber, a substrate support unit, a gas injection unit, and at least one RF power source. The substrate support unit includes a heater and an RF energy blocking part installed above the heater. A current, voltage and power measurement module is installed adjacent to a grounding wire, which is connected to the RF energy blocking part, to measure the RF voltage, current, and power of an incident wave and a reflected wave generated by the plasma.

## Description

### BACKGROUND

The present invention relates to a substrate processing equipment, and more particularly, to a substrate processing equipment equipped with a current, voltage and power measurement module for measuring the current/voltage applied for generating and maintaining plasma during substrate processing using plasma, and further for measuring the power of incident and reflected waves.

A substrate processing equipment refers to an equipment that processes a substrate by forming a plasma state in a sealed processing space.

The substrate processing equipment may include a plasma source having various structures, such as Capacitively Coupled Plasma (CCP) and Inductively Coupled Plasma (ICP), depending on the plasma formation principle.

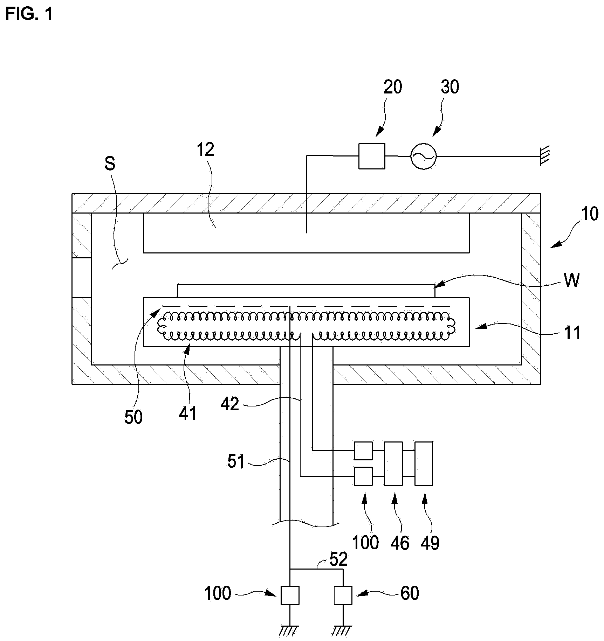

For example, as shown in FIG. 1, a substrate processing equipment generally includes: a process chamber (10) that forms a sealed processing space (S) in which plasma is formed to process a substrate; a substrate support unit (11) which is disposed in the processing space (S) and on which a substrate (W) is placed; and a gas injection unit (12) that injects gas for performing a process into the processing space (S).

Meanwhile, various methods for monitoring the plasma state to control the plasma formed in the processing space (S) are suggested to perform uniform and reproducible substrate processing.

A VI probe is provided as a means for directly measuring the plasma state generated in the processing space (S) of a substrate processing equipment. Although the conventional VI probe secures accuracy in RF voltage/current measurement, it has a problem in that it is difficult to secure reliability for transmitted power measurement with the conventional technology that calculates transmitted power as IVcos(θ) by measuring the phase difference from the RF voltage and current waveforms.

That is, the conventional commercialized method for measuring transmitted power using phase difference (VI probe), which is used to measure the plasma state generated in the processing space (S) of the substrate processing equipment, has many difficulties in accurately measuring and controlling the RF power delivered to the plasma.

### SUMMARY

An object of the present invention is to provide a substrate processing equipment capable of measuring the power applied for plasma formation, which is configured to have both capacitor and inductor properties to detect scalar values, i.e., the amount of forward power and reflect power, rather than relying on the principle of vectors, such as detecting the phase difference between voltage and current for RF power measurement.

To achieve the above object, the present invention provides a substrate processing equipment comprising: a process chamber 10 forming a sealed processing space S in which plasma is formed to perform substrate processing; a substrate support unit 11 disposed in the processing space S on which a substrate W is seated; a gas injection unit 12 for injecting a process gas into the processing space S; and at least one power source 30 for applying an RF current of a predetermined frequency to at least one of the substrate support unit 11 and the gas injection unit 12, wherein the substrate support unit 11 includes a heater 41 for heating the seated substrate W, an RF energy blocking part 50 is installed above the heater 41 to minimize the transfer of RF energy to the heater 41, and a current, voltage and power measurement module 100 is installed adjacent to a grounding wire 51, one end of which is connected to the RF energy blocking part 50 and the other end is grounded, to measure the RF voltage, current, and power of an incident wave and a reflected wave generated by the plasma in the processing space S.

The current, voltage and power measurement module 100 may include a first directional coupler 300 for measuring the power output by the incident wave and a second directional coupler 400 for measuring the power output by the reflected wave.

The first directional coupler 300 may include: an LC combination circuit part 310 in which a capacitance element 311 and an inductance element 312, which are disposed adjacent to the grounding wire 51 and interact with a heater power line 42, are combined and which is wound based on a direction of the incident wave flowing through the heater power line 42; and a resistance element part 320 including a first reference resistance element 321 having one end that is grounded and the other end connected to one end of the LC combination circuit part 310, and a second reference resistance element 322 having one end connected to a first output port 323 and the other end connected to one end of the LC combination circuit part 310.

The second directional coupler 400 may include: an LC combination circuit part 410 in which a capacitance element 411 and an inductance element 412, which are disposed adjacent to the grounding wire 51 and interact with the heater power line 42, are combined and which is wound based on a direction of the reflected wave flowing through the heater power line 42; and a resistance element part 420 including a third reference resistance element 421 having one end that is grounded and the other end connected to one end of the LC combination circuit part 410, and a fourth reference resistance element 422 having one end connected to a second output port 423 and the other end connected to one end of the LC combination circuit part 410.

The first directional coupler 300 may include at least one filter part 330 disposed at a branch point between the resistance element part 320 and the LC combination circuit part 310.

The second directional coupler 400 may include at least one filter part 430 disposed at a branch point between the resistance element part 420 and the LC combination circuit part 410.

The equipment may further comprise a PCB 220 having an insertion part 210 with an inner diameter greater than an outer diameter of the heater power line 42 so that at least a portion of the heater power line 42 is inserted therein, wherein the capacitance element 311 of the first directional coupler 300 and the capacitance element 411 of the second directional coupler 400 comprise a plurality of capacitance parts 311a, 411a spaced apart from each other along a circumferential direction on an inner circumferential surface of the insertion part 210, and the inductance element 312 of the first directional coupler 300 and the inductance element 412 of the second directional coupler 400 comprise winding parts 340, 440 passing through the PCB 220 and wound at least one time to connect the ends of adjacent capacitance parts 311a, 411a.

The winding parts 340, 440 may include metal pattern parts 341, 441 formed on top and bottom surfaces of the PCB 220 and vertical connection parts 342, 442 passing through the PCB 220 to electrically connect the metal pattern parts 341, 441.

The voltage measurement unit 500 may include: a capacitance part 510 formed along a circumferential direction at a predetermined angle on at least one of an inner circumferential surface of the insertion part 210 and top and bottom surfaces of an edge of the insertion part 210; and a third output port part 720 connected to the capacitance part 510.

At least one of a resistance element part 520 and a third filter part 530 may be disposed between a branch point between the capacitance part 510 and the third output port part 720 and a first ground part 740.

The current measurement unit 600 may include: an inductance part 610 passing through the PCB 220 concentrically with the voltage measurement unit 500 but further from the inner circumferential surface of the insertion part 210 than the voltage measurement unit 500 and winding at least one time; and a fourth output port part 710 connected to the inductance part 610.

At least one of a resistance element part 620 and a fourth filter part 630 may be disposed between a branch point between the inductance part 610 and the fourth output port part 710 and a second ground part 730.

An RF filter 46 may be additionally installed to block RF energy generated by the RF current from the power source 30 from being transmitted through the heater power line 42 to a heater power supply 49.

A plasma control unit 60 may be additionally installed, connected to the heater power line 42, to control the plasma generated in the processing space S using the current, voltage and power measured by the current, voltage and power measurement module 100.

The current, voltage and power measurement module 100 and the plasma control unit 60 may be configured as a single module.

The plasma control unit 60 may be installed on the PCB 220 of the current, voltage and power measurement module 100.

The present invention also discloses a current, voltage and power measurement module for a substrate processing equipment having the above configuration, wherein a plasma control unit 60, which is connected to the heater power line 42 and controls the plasma in the processing space S using the measured current, voltage and power, is configured as a single module with the current, voltage and power measurement module 100.

### BRIEF DESCRIPTION OF THE FIGURES

The accompanying drawings are included to provide a further understanding of the inventive concept and are incorporated in and constitute a part of this specification. The drawings illustrate exemplary embodiments of the inventive concept and, together with the description, serve to explain the principles of the inventive concept. In the drawings:
FIG. 1 is a conceptual view illustrating an example of a substrate processing equipment according to the present invention.
FIG. 2 is a perspective view illustrating an example of a PCB of the current, voltage and power measurement module installed in the substrate processing equipment of FIG. 1.
FIGS. 3a and 3b are a plan view and a rear view, respectively, illustrating the PCB of FIG. 2.
FIG. 4a is a conceptual view illustrating a concept realized as a circuit on the PCB of FIG. 2.
FIG. 4b is an enlarged perspective view illustrating portion A of FIG. 4a.
FIG. 4c is an enlarged perspective view illustrating portion B of FIG. 4a.
FIG. 5 is a cross-sectional view taken along line V-V of FIG. 2.
FIG. 6 is a cross-sectional view illustrating an inductance part of a current measurement unit of FIG. 2.
FIG. 7 is an equivalent circuit diagram illustrating a first directional coupler and a second directional coupler of the current, voltage and power measurement module.
FIG. 8 is an equivalent circuit diagram illustrating a voltage measurement unit and a current measurement unit of the current, voltage and power measurement module.

### DETAILED DESCRIPTION

Hereinafter, a substrate processing equipment according to the present invention will be described with reference to the accompanying drawings.

First, the substrate processing equipment according to the present invention is an equipment that performs a predetermined function by forming plasma, and it can have various configurations depending on the application of the plasma.

For example, the substrate processing equipment according to the present invention is an equipment that performs substrate processing such as deposition and etching by forming plasma in a processing space S. It can have various configurations for plasma formation structures such as Inductively Coupled Plasma (ICP) and Capacitively Coupled Plasma (CCP).

The substrate processing equipment, as an example shown in FIG. 1, may include: a process chamber 10 that forms a sealed processing space S in which plasma is formed to perform substrate processing; a substrate support unit 11 disposed in the processing space S on which a substrate W is seated; a gas injection unit 12 that injects a gas for performing a process into the processing space S; and at least one power source 30 for applying an RF current of a predetermined frequency to at least one of the substrate support unit 11 and the gas injection unit 12.

The process chamber 10 is a component that forms a sealed processing space S in which plasma is formed to perform substrate processing, and various configurations are possible.

For example, the process chamber 10 may be composed of a container in which the processing space S is formed and an upper lid detachably coupled to the upper side of the container.

The substrate support unit 11 is a component installed in the processing space S on which the substrate W is seated, and various configurations are possible.

For example, the substrate support unit 11 may include a susceptor part on which the substrate W is seated and a support rod part extending from the bottom surface of the susceptor part to support the susceptor part.

In particular, the substrate support unit 11 is equipped with a heater 41 for heating the seated substrate W.

The heater 41 is a component installed in the substrate support unit 11 that is supplied with power by a heater power line 46 connected to a heater power supply 49 to heat the seated substrate W, and various configurations are possible.

Furthermore, the heater 41 may be installed in various patterns to perform uniform substrate processing on the seated substrate W.

Meanwhile, as RF power is applied for plasma formation in the processing space S, RF energy can be transmitted through the heater power line 46 connected to the heater 41 to the heater power supply 49, which can cause energy loss as well as damage or malfunction of the heater power supply 49.

Accordingly, it is preferable that the heater power line 46 is additionally provided with an RF filter 46 to block RF energy generated by the RF current applied by the power source 30 from being transmitted through the heater power line 42 to the heater power supply 49 for supplying power to the heater 41.

The RF filter 46 is a component installed on the heater power line 46 to block RF energy generated by the RF current applied by the power source 30 from being transmitted to the heater power supply 49, and it may be configured by at least one of a coil and a capacitor.

The gas injection unit 12 is a component for injecting a process gas into the processing space S, and various configurations are possible depending on the gas injection structure.

For example, the gas injection unit 12 may be configured as a showerhead that injects gas supplied through a gas supply pipe installed above it in a downward direction.

The power source 30 is a component, of which one or more are installed to apply an RF current of a predetermined frequency to at least one of the substrate support unit 11 and the gas injection unit 12, and various configurations are possible depending on the power application method and applied frequency.

The one or more RF power sources 30 apply RF power to at least one of the process chamber 10, the gas support unit 11, and the gas injection unit 12, and a matching network 20 is installed between the RF power source 30 and a power application line 110.

And the RF power source 30 can supply RF current of a predetermined frequency such as high frequency and low frequency depending on the process conditions.

Meanwhile, as described above, RF current is applied to form plasma in the processing space S, and the RF energy generated by the applied RF current can be transmitted to the heater power supply 49 through the heater power line 42.

Accordingly, the substrate support unit 11 may have an RF energy blocking part 50 installed above the heater 41 to minimize the transfer of RF energy to the heater 41.

The RF energy blocking part 50 is a component installed above the heater 41 to minimize the transfer of RF energy to the heater 41, and various configurations are possible.

As an example, as shown in FIG. 1, the RF energy blocking part 50 may be composed of a metallic mesh installed above the heater 41.

Meanwhile, since RF energy is transmitted to the RF energy blocking part 50, it is possible to measure the RF voltage, current, and the power of the incident and reflected waves generated by the plasma in the processing space S through the RF energy blocking part 50.

Accordingly, a current, voltage and power measurement module 100 may be installed adjacent to a grounding wire 51, one end of which is connected to the RF energy blocking part 50 and the other end is grounded, to measure the RF voltage, current, and power of the incident and reflected waves generated by the plasma in the processing space S.

The current, voltage and power measurement module 100, as shown in FIG. 1, is characterized by being installed adjacent to the grounding wire 51 to measure the RF voltage, current, and power of the incident and reflected waves generated by the plasma in the processing space S.

Here, the current, voltage and power measurement module 100 can have various configurations depending on the principles of measuring current, voltage, and particularly power.

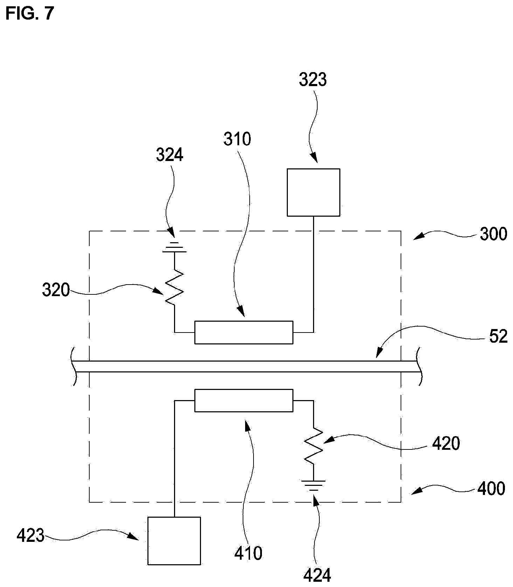

For example, the current, voltage and power measurement module 100, as shown in FIGS. 7 to 8, may include: a first directional coupler 300 disposed adjacent to the grounding wire 51 to measure the power output by the incident wave; a second directional coupler 400 disposed adjacent to the heater power line 42 to measure the power output by the reflected wave; a voltage measurement unit 500 disposed adjacent to the grounding wire 51 to measure the RF voltage using the capacitance principle; and a current measurement unit 600 disposed adjacent to the grounding wire 51 to measure the RF current using the inductance principle.

The voltage measurement unit 500 is a component disposed adjacent to the grounding wire 51 to measure the RF voltage using the capacitance principle, and various configurations are possible.

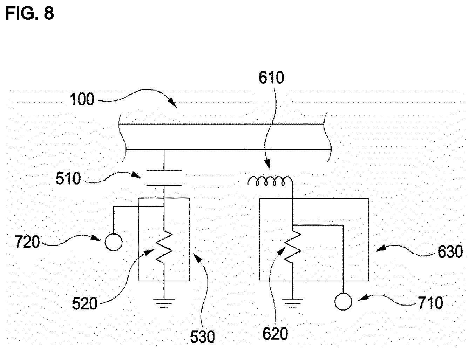

For example, the voltage measurement unit 500, as shown in FIG. 8, may include a capacitance part 510 disposed adjacent to the heater power line 42, and a third output port part 720 connected to the capacitance part 510 to measure the voltage of the incident wave.

The capacitance part 510 is a component disposed adjacent to the heater power line 42, which can have various configurations, such as being composed of a capacitor conductor made of a material like copper that forms a capacitor in a circuit, installed at a predetermined distance from the outer circumferential surface of the heater power line 42.

Of course, a dielectric material for adjusting the dielectric constant may be formed between the outer circumferential surface of the heater power line 42 and the capacitor conductor.

The third output port part 720 is a component connected to the capacitance part 510 to measure the voltage of the incident wave applied to the heater power line 42, and various configurations are possible.

Particularly, the third output port part 720 may be formed in the shape of a wire at the edge of a PCB 220, which will be described later.

And it is preferable that the third output port part 720 is connected to the midpoint based on the length of the capacitance part 510.

Meanwhile, at least one of a resistance element part 520 and a third filter part 530 may be installed between a branch point between the third output port part 720 and the capacitance part 510 and a first ground part 740.

The first ground part 740 is a component for grounding through coupling with an external terminal and may be configured similarly to the ground terminal described later.

The resistance element part 520 and the third filter part 530 are electrical elements installed to stably measure the voltage of the incident wave from the electrical signal output to the third output port part 720. The third filter part 530 may be configured by a combination of a resistor, a capacitor, a coil, and the like.

The current measurement unit 600 is a component disposed adjacent to the grounding wire 51 to measure the RF current using the inductance principle, and various configurations are possible.

For example, the current measurement unit 600, as shown in FIG. 8, may include an inductance part 610 disposed adjacent to the heater power line 42, and a fourth output port part 710 connected to the inductance part 610 to measure the current flowing through the heater power line 42.

The inductance part 610 is a component disposed adjacent to the heater power line 42, which can have various configurations, such as being composed of an inductance wire made of a material like copper that forms an inductance in a circuit, installed at a predetermined distance from the outer circumferential surface of the heater power line 42.

The fourth output port part 710 is a component connected to the inductance part 610 to measure the current flowing through the heater power line 42, and various configurations are possible.

Particularly, the fourth output port part 710 may be formed in the shape of a wire at the edge of the PCB 220, which will be described later.

And it is preferable that the fourth output port part 710 is connected to one end based on the length of the inductance part 610.

Meanwhile, at least one of a resistance element part 620 and a fourth filter part 630 may be installed between a branch point between the fourth output port part 710 and the inductance part 610 and a second ground part 730.

The second ground part 730 is a component for grounding through coupling with an external terminal and may have a configuration similar to that of a ground terminal that will be described later.

The resistance element part 620 and the fourth filter part 630 (translator's note: original text mistakenly refers to 520 and 530, corrected to 620 and 630 for context) are electrical elements installed to stably measure the voltage of the incident wave from the electrical signal output to the fourth output port part 710. The fourth filter part 630 may be configured by a combination of a resistor, a capacitor, a coil, and the like.

The first directional coupler 300 is a component disposed adjacent to the grounding wire 51 to measure the power output by the incident wave, and various configurations are possible.

For example, the first directional coupler 300, as shown in FIG. 8, may include: an LC combination circuit part 310 in which a capacitance element 311 and an inductance element 312, which are disposed adjacent to the grounding wire 51 and interact with the heater power line 42, are combined and which is wound based on a direction of the incident wave flowing through the heater power line 42; and a resistance element part 320 including a first reference resistance element 321 having one end that is grounded and the other end connected to one end of the LC combination circuit part 310, and a second reference resistance element 322 having one end connected to a first output port 323 and the other end connected to one end of the LC combination circuit part 310.

The LC combination circuit part 310 is a component in which a capacitance element 311 and an inductance element 312, which are disposed adjacent to the grounding wire 51 and interact with the heater power line 42, are combined and wound based on the direction of the incident wave flowing through the heater power line 42, and various configurations are possible, such as the combination of the capacitance element 311 and the inductance element 312.

Particularly, it is preferable that the inductance element 312 has a winding structure in a forward direction based on the traveling direction of the incident wave, i.e., a counter-clockwise direction, in consideration of measuring the power of the incident wave.

Also, considering a merged structure, if the capacitance element 311 and the inductance element 312 form one coil as a whole, a plate surface may be formed in a direction toward the outer circumferential surface of the heater power line 42 so that a portion of the coil forms the capacitor part.

The LC combination circuit part 310 may form one circuit by combining the capacitance element 311 and the inductance element 312.

The resistance element part 320 includes a first reference resistance element 321 having one end that is grounded and the other end connected to one end of the LC combination circuit part 310, and a second reference resistance element 322 having one end connected to the first output port 323 and the other end connected to one end of the LC combination circuit part 310, and can have various configurations.

The first reference resistance element 321, having one end grounded and the other end connected to one end of the LC combination circuit part 310, may have a preset resistance value, e.g., 50Ω.

Here, when the first reference resistance element 321 is installed on the PCB 220, it may be formed in the shape of a ground terminal 324 at the edge of the PCB 220, which will be described later.

The second reference resistance element 322, having one end connected to the first output port 323 and the other end connected to one end of the LC combination circuit part 310, may have a preset resistance value, e.g., the same resistance value as the first reference resistance element 321.

Here, the first output port 323 may be formed as a terminal at the edge of the PCB 220, which will be described later.

Meanwhile, the first directional coupler 300 may have at least one filter part 330 installed at a branch point between the resistance element part 320 and the LC combination circuit part 310.

The filter part 330 is an electric element installed at a branch point between the resistance element part 320 and the LC combination circuit part 310, and may be composed of a capacitor, a coil, and the like.

The second directional coupler 400 is a component disposed adjacent to the grounding wire 51 to measure the power output by the reflected wave, and various configurations are possible.

For example, the second directional coupler 400, as shown in FIG. 8, may include: an LC combination circuit part 410 in which a capacitance element 411 and an inductance element 412, which are disposed adjacent to the grounding wire 51 and interact with the heater power line 42, are combined and which is wound based on a direction of the reflected wave flowing through the heater power line 42; and a resistance element part 420 including a third reference resistance element 421 having one end that is grounded and the other end connected to one end of the LC combination circuit part 410, and a fourth reference resistance element 422 having one end connected to a second output port 423 and the other end connected to one end of the LC combination circuit part 410.

The LC combination circuit part 410 is a component combined with the capacitance element 411 and the inductance element 412, and various configurations are possible.

Particularly, it is preferable that the inductance element 412 has a winding structure in a forward direction based on the traveling direction of the reflected wave, i.e., a counter-clockwise direction-since the incident wave and the reflected wave are in opposite directions, the winding direction of the inductance element 312 of the first directional coupler 300 and the winding direction of the inductance element 412 of the second directional coupler 400 are opposite to each other.

Also, considering a merged structure, if the capacitance element 411 and the inductance element 412 form one coil as a whole, a plate surface may be formed in a direction toward the outer circumferential surface of the heater power line 42 so that a portion of the coil forms the capacitor part.

The LC combination circuit part 410 may be combined with the capacitance element 411 and the inductance element 412 to form one circuit.

The resistance element part 420 includes a third reference resistance element 421 having one end that is grounded and the other end connected to one end of the LC combination circuit part 410, and a fourth reference resistance element 422 having one end connected to the second output port 423 and the other end connected to one end of the LC combination circuit part 410, and can have various configurations.

The third reference resistance element 421, having one end grounded and the other end connected to one end of the LC combination circuit part 410, may have a preset resistance value, e.g., 50Ω.

Here, when the third reference resistance element 421 is installed on the PCB 220, it may be formed in the shape of a ground terminal 424 at the edge of the PCB 220, which will be described later.

The fourth reference resistance element 422, having one end connected to the second output port 423 and the other end connected to one end of the LC combination circuit part 410, may have a preset resistance value, e.g., the same resistance value as the third reference resistance element 421.

Here, the second output port 423 may be formed as a terminal at the edge of the PCB 220, which will be described later.

Meanwhile, the second directional coupler 400 may have at least one filter part 430 installed at a branch point between the resistance element part 420 and the LC combination circuit part 410.

The filter part 430 is an electric element installed at a branch point between the resistance element part 420 and the LC combination circuit part 410, and may be composed of a capacitor, a coil, and the like.

Meanwhile, the substrate processing equipment according to the present invention having the above-described configuration may be configured as one module by including one PCB 220.

That is, the substrate processing equipment according to the present invention may include the PCB 220 in which an insertion part 210 having an inner diameter greater than an outer diameter of the heater power line 42 is formed so that at least a portion of the heater power line 42 is inserted thereto.

The insertion part 210 may be formed in various shapes such as an arc or circle with one side opened, considering that the cross-sectional shape of the heater power line 42 is circular, so that the capacitance elements 311, 411 and inductance elements 312, 412, which will be described later, have the same condition.

Alternatively, the insertion part 210 may have a polygonal shape depending on conditions, such as when the cross-section of the heater power line 42 is rectangular.

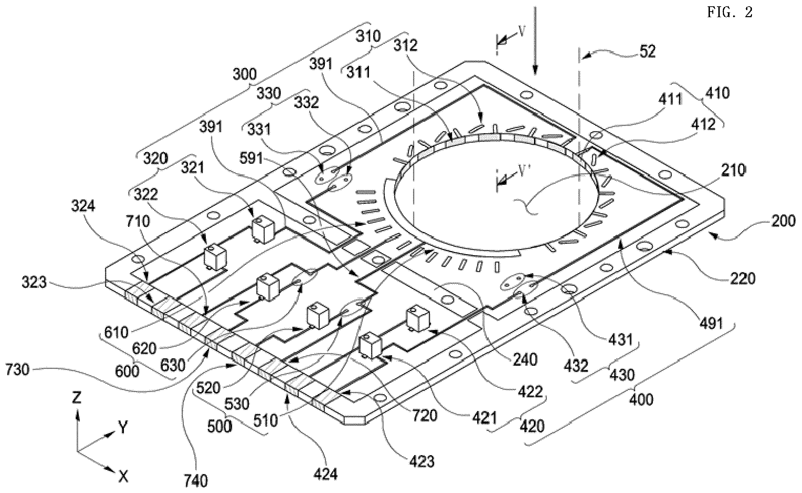

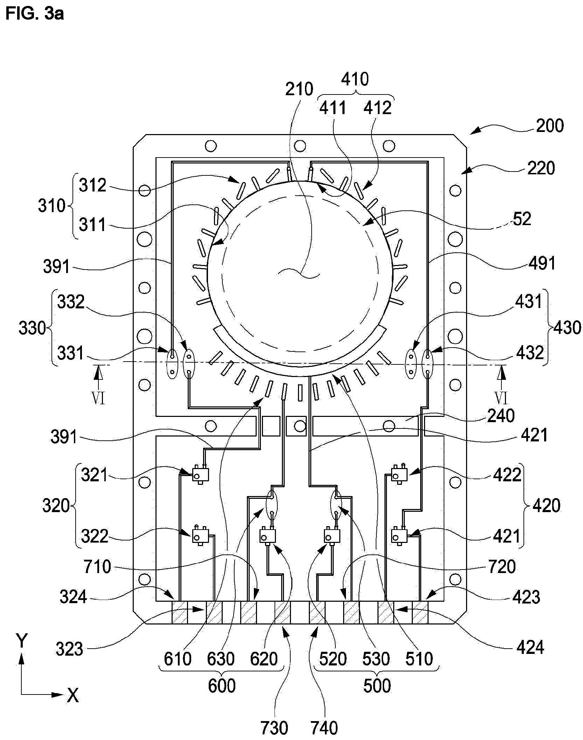

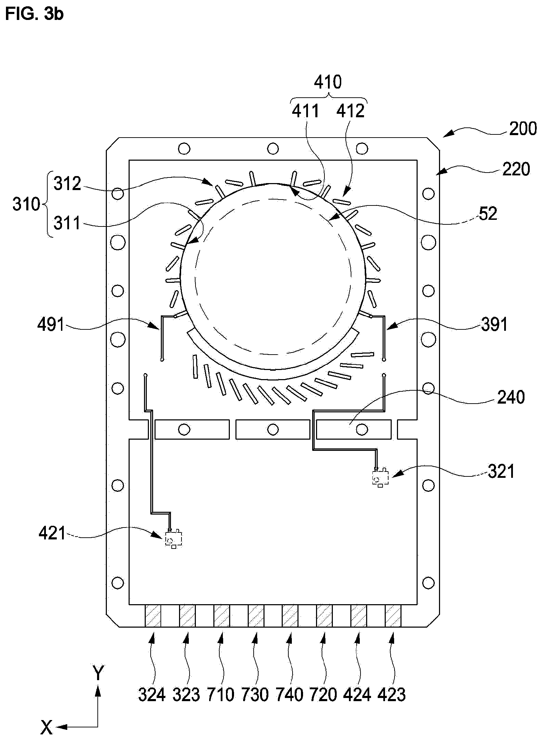

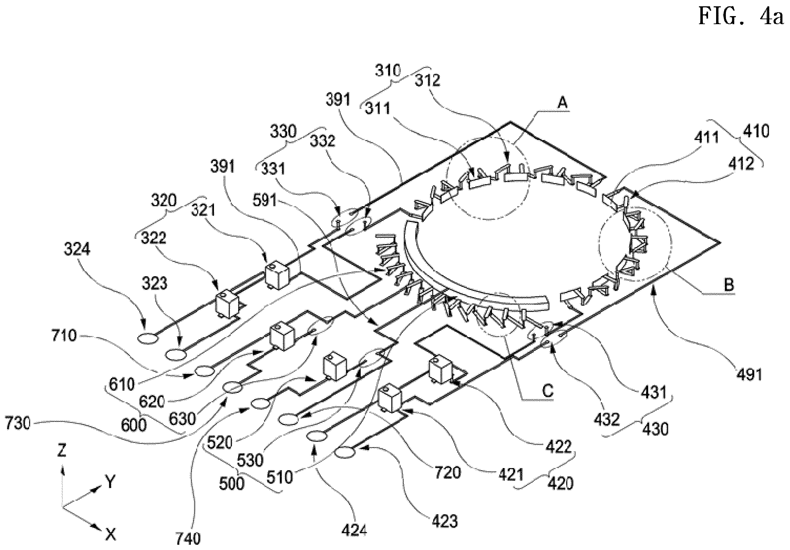

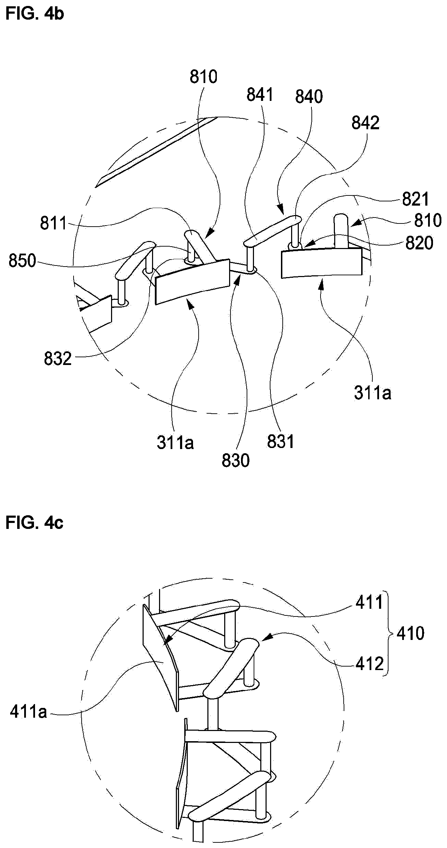

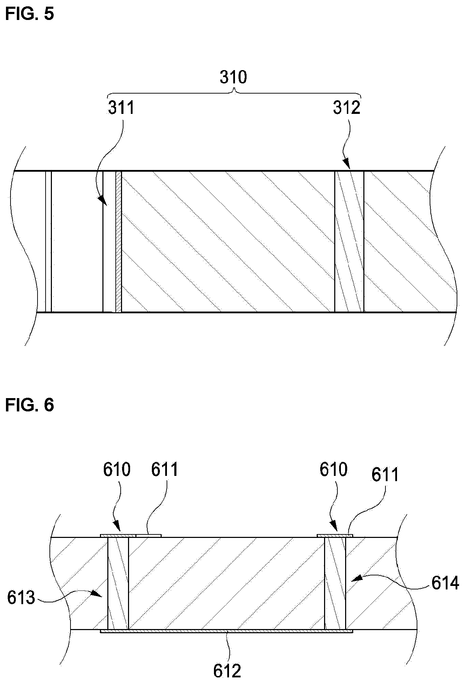

Meanwhile, the capacitance element 311 of the first directional coupler 300 and the capacitance element 411 of the second directional coupler 400, as shown in FIGS. 2 to 5, may include a plurality of capacitance parts 311a, 411a spaced apart from each other along a circumferential direction on an inner circumferential surface of the insertion part 210, and the inductance element 312 of the first directional coupler 300 and the inductance element 412 of the second directional coupler 400 may include winding parts 340, 440 passing through the PCB 220 and wound at least one time to connect the ends of adjacent capacitance parts 311a, 411a.

In a specific embodiment, the capacitance element 311 of the first directional coupler 300 and the capacitance element 411 of the second directional coupler 400 may include a plurality of capacitance parts 311a, 411a made of a conductive material such as copper, arranged along a predetermined arc angle on the inner circumferential surface of the insertion part 210.

The plurality of capacitance parts 311a, 411a may each have a rectangular shape in an unfolded state and be spaced at a predetermined distance from each other along the inner circumferential surface of the insertion part 210.

Meanwhile, the winding parts 340, 440 are the inductance element 312 of the first directional coupler 300 and the inductance element 412 of the second directional coupler 400, which pass through the PCB 220 and are wound at least one time to connect the ends of adjacent capacitance parts 311a, 411a, and can have various configurations depending on the coil winding structure.

In a specific embodiment, the winding parts 340, 440 may include metal pattern parts 810, 820, 830, 840 formed on the top and bottom surfaces of the PCB 220, and a vertical connection part 850 that passes through the PCB 220 vertically to electrically connect the metal pattern parts 810, 820, 830, 840.

The metal pattern parts 810, 820, 830, 840 are metal patterns formed on the top and bottom surfaces of the PCB 220 that form one coil together with the vertical connection part 850, and can be formed in various patterns.

For example, the metal pattern parts 810, 820, 830, 840 may include: a first upper component 810 extending radially on the top surface of the PCB 220 from the rear end of the capacitance part 311a in a clockwise direction and having a first connection point 811 at its end; a first lower component 820 extending radially on the bottom surface of the PCB 220 from the front end of the capacitance part 311a in the clockwise direction and having a second connection point 821 at its end; a second lower component 830 connecting a third connection point 832 set directly below the first connection point 811 to a fourth connection point 831 set on the bottom surface of the PCB 220 between adjacent capacitance parts 311a in the clockwise direction; and a second upper component 840 connecting a fifth connection point 841 located directly above the fourth connection point 831 to a sixth connection point 842 set directly above the second connection point 821.

The first upper component 810, the second upper component 840, the first lower component 820, and the second lower component 830 are parts made of a conductive material such as copper on the top and bottom surfaces of the PCB 220, which form an inductance component as a whole together with the capacitance parts 311a, 411a and the vertical connection part 850 that will be described later, and can have various configurations.

Meanwhile, the first connection point 811 to the sixth connection point 842 are points set as portions where the vertical connection part 850 is vertically connected to the first upper component 810, the second upper component 840, the first lower component 820, and the second lower component 830, and can have various configurations depending on the connection structure.

Particularly, the fifth connection point 841 and the fourth connection point 831 may be formed closer to the inner peripheral surface of the insertion part 210 than the first connection point 811 and the second connection point 821.

The vertical connection part 850 is a component that passes through the PCB 220 vertically and electrically connects the metal pattern parts 810, 820, 830, 840, and may include a plurality of connection members 850 that vertically and electrically connect the first connection point 811 and the third connection point 832, the sixth connection point 842 and the second connection point 821, and the fifth connection point 841 and the fourth connection point 831, respectively.

Meanwhile, the metal pattern part 441 and vertical connection part 442 of the second directional coupler 400 are formed linearly symmetrical to the metal pattern parts 810, 820, 830, 840 and vertical connection part 850 of the first directional coupler 300 with respect to the center of the insertion part 210, as shown in FIGS. 2 to 5, so a detailed description thereof will be omitted.

For reference, since the inductance component of the second directional coupler 400 is opposite to that of the first directional coupler 300, if the first directional coupler 300 is formed based on the clockwise direction, the second directional coupler 400 is formed based on the counter-clockwise direction.

Meanwhile, in the PCB 220, the LC combination circuit parts 310, 410 of the first directional coupler 300 and the second directional coupler 400 may be formed on one side, and the remaining components, such as the resistance element parts 320, 420 and at least a portion of the filter parts 330, 430, may be formed on the other side.

Also, the PCB 220 having the above-described configuration may have a rectangular planar shape and be divided into a first area on which the LC combination circuit parts 310, 410 and the insertion part 210 are formed, and a second area which adjoins the first area and on which the resistance element parts 320, 420 are disposed.

Meanwhile, the LC combination circuit parts 310, 410 disposed in the first area and the resistance element parts 320, 420 disposed in the second area may be electrically connected by at least one wire pattern 390, 490 formed on at least one of the top and bottom surfaces of the PCB 220.

Particularly, the wire patterns 390, 490 may be appropriately arranged on the top and bottom surfaces of the PCB 220 to effectively connect the LC combination circuit parts 310, 410 in the first area and the resistance element parts 320, 420 in the second area.

And between the first area and the second area, at least one wire pattern 240 for blocking electromagnetic waves from the first area where the LC combination circuit parts 310, 410 are installed may be formed on at least one of the top and bottom surfaces.

Meanwhile, the voltage measurement unit 500 may be integrated into the PCB 220.

Specifically, the capacitance part 510 may be formed along a circumferential direction at a predetermined angle on at least one of the inner circumferential surface of the insertion part 210 and the top and bottom surfaces of the edge of the insertion part 210 in the first area of the PCB 220.

Here, the capacitance part 510 may be located between the capacitance element 311 of the LC combination circuit part 310 of the first directional coupler 300 and the capacitance element 411 of the LC combination circuit part 410 of the second directional coupler 400, based on the circumferential direction of the insertion part 210.

And the resistance element part 520 may be installed in the second area of the PCB 220.

And the resistance element part 520 may be electrically connected to the capacitance part 510 by a wire pattern 590 formed on at least one of the top and bottom surfaces of the PCB 220.

Also, the third filter part 530 may be set at an arbitrary point on the PCB 220, which is a branch point from the wire pattern 590 between the resistance element part 520 and the capacitance part 510.

Also, the current measurement unit 600 may be integrated into the PCB 220.

The inductance part 610 may be formed in the first area by passing through the PCB 220, concentric with the voltage measurement unit 500 but further from the inner circumferential surface of the insertion part 210, and winding at least one time.

Specifically, the inductance part 610 may include: a plurality of upper components 611 extending in the radial direction of the insertion part 210 and spaced apart in the circumferential direction on the top surface of the PCB 220; a lower component 612 connecting a first lower connection point, located by passing through the PCB 220 from a first upper connection point at one outer end of the upper component 611, and a second lower connection point at the inner other end of an adjacent upper component 611; a first connection part 613 that electrically connects the first upper connection point and the first lower connection point vertically; and a second connection part 614 that vertically and electrically connects a second upper connection point to a second lower connection point located by passing through the PCB 220 from the second upper connection point.

Meanwhile, the resistance element part 620 may be installed in the second area of the PCB 220.

And the resistance element part 620 may be electrically connected to the inductance part 610 by a wire pattern 690 formed on at least one of the top and bottom surfaces of the PCB 220.

And the fourth filter part 630 may be set at an arbitrary point on the PCB 220, which is a branch point from the wire pattern 690 between the resistance element part 620 and the inductance part 610.

Meanwhile, on the PCB 220, the first output port 323 and ground terminal 324, the second output port 423 and ground terminal 424, the first ground part 740, the second ground part 730, the third output port 720, and the fourth output port 710 may be formed as terminals at the edge of the second area.

The terminals formed on the PCB 220 can be connected to an external module, and electrical signals are output through each output port 323, 423, 710, 720, enabling the measurement of current, voltage and power.

Meanwhile, the current, voltage and power measurement module 100 may measure the power of the incident and reflected waves by using the first directional coupler 300 and the second directional coupler 400.

However, since the electrical signals output through the first directional coupler 300 and the second directional coupler 400 are output with a lot of noise, proper extraction and verification are required.

Accordingly, the current, voltage and power measurement module 100 can measure the voltage and current applied to the grounding wire 51, and the power of the incident and reflected waves, through a pre-established lookup table, relational expressions, etc., obtained from experiments performed in advance according to process conditions.

Meanwhile, in the present invention, although a configuration including all of the voltage measurement unit 500, the current measurement unit 600, the first directional coupler 300 for measuring incident wave power, and the second directional coupler 400 for measuring reflected wave power has been described, the present invention can, of course, be configured by a combination of at least one of the voltage measurement unit 500, the current measurement unit 600, the first directional coupler 300, and the second directional coupler 400 as needed.

In particular, the present invention can, of course, implement a combination of at least one of the voltage measurement unit 500, the current measurement unit 600, the first directional coupler 300, and the second directional coupler 400 on a single PCB as needed.

Meanwhile, as described above, an RF filter 46 may be additionally installed to block the RF energy generated by the RF current applied by the power source 30 from being transmitted through the heater power line 42 to the heater power supply 49 for supplying power to the heater 41.

At this time, the current, voltage and power measurement module 100 and the RF filter 46 may be configured as a single module.

In particular, the RF filter 46 may be installed on the PCB 220 that constitutes the current, voltage and power measurement module 100.

Meanwhile, as described above, the current, voltage and power can be measured by the current, voltage and power measurement module 100 installed adjacent to the grounding wire 51.

Accordingly, by additionally installing a plasma control unit 60 connected to the grounding wire 51 that controls the plasma generated in the processing space S using the current, voltage and power measured by the current, voltage and power measurement module 100, the plasma for substrate processing can be easily controlled.

The plasma control unit 60 is a component that controls the plasma generated in the processing space S using the current, voltage and power measured by the current, voltage and power measurement module 100, and various configurations are possible.

For example, the plasma control unit 60 may be composed of a branch line 52 branched from the grounding wire 51 and an electrical element having one end connected to the branch line 52 and the other end grounded.

And the electrical element may include a variable capacitor and/or a variable coil, whose values can be changed using the current, voltage and power measured by the current, voltage and power measurement module 100.

Meanwhile, the current, voltage and power measurement module 100, as shown in FIG. 1, may be installed adjacent to the power application line 42 that supplies power to the heater, either alternatively or additionally.

The above is a description of only some of the preferred embodiments that can be implemented by the present invention, and as is well known, the scope of the present invention should not be interpreted as being limited to the above embodiments, and all technical ideas that share the fundamental technical spirit of the present invention described above shall be included in the scope of the present invention.

## Claims

1. A substrate processing equipment, comprising:
a process chamber forming a sealed processing space in which plasma is formed to perform substrate processing;
a substrate support unit disposed in the processing space on which a substrate is seated;
a gas injection unit configured to inject a gas for performing a process into the processing space; and
at least one power source for applying an RF current of a predetermined frequency to at least one of the substrate support unit and the gas injection unit,
wherein the substrate support unit includes a heater for heating the seated substrate, and an RF energy blocking part is installed above the heater to minimize the transfer of RF energy to the heater, and
a current, voltage and power measurement module is installed adjacent to a grounding wire, one end of which is connected to the RF energy blocking part and the other end is grounded, to measure an RF voltage, current, and power of an incident wave and a reflected wave generated by plasma generated in the processing space.

2. The substrate processing equipment of claim 1, further comprising:
a first directional coupler disposed adjacent to the grounding wire to measure the power output by the incident wave;
a second directional coupler disposed adjacent to the grounding wire to measure the power output by the reflected wave;
a voltage measurement unit disposed adjacent to the grounding wire to measure the RF voltage by using capacitance; and
a current measurement unit disposed adjacent to the grounding wire to measure the RF current by using inductance.

3. The substrate processing equipment of claim 2, wherein the first directional coupler and the second directional coupler comprise inductance elements having different winding directions.

4. The substrate processing equipment of claim 3, wherein the first directional coupler comprises:
an LC combination circuit part in which a capacitance element and an inductance element, which are disposed adjacent to the grounding wire and interact with a heater power line, are combined and which is wound based on a direction of the incident wave flowing through the heater power line; and
a resistance element part comprising a first reference resistance element having one end that is grounded and the other end connected to one end of the LC combination circuit part and a second reference resistance element having one end connected to a first output port and the other end connected to one end of the LC combination circuit part, and
the second directional coupler comprises:
an LC combination circuit part in which a capacitance element and an inductance element, which are disposed adjacent to the grounding wire and interact with the heater power line, are combined and which is wound based on a direction of the reflected wave flowing through the heater power line; and
a resistance element part comprising a third reference resistance element having one end that is grounded and the other end connected to one end of the LC combination circuit part and a fourth reference resistance element having one end connected to a second output port and the other end connected to one end of the LC combination circuit part.

5. The substrate processing equipment of claim 4, wherein the first directional coupler comprises at least one filter part disposed at a branch point branched between the resistance element part and the LC combination circuit part, and
the second directional coupler comprises at least one filter part installed at a branch point branched between the resistance element part and the LC combination circuit part.

6. The substrate processing equipment of claim 4, further comprising a PCB in which an insertion part having an inner diameter greater than an outer diameter of the heater power line so that at least a portion of the heater power line is inserted thereto,
wherein a capacitance element of the first directional coupler and a capacitance element of the second directional coupler comprise a plurality of capacitance parts spaced apart from each other along a circumferential direction on an inner circumferential surface of the insertion part, and
an inductance element of the first directional coupler and the inductance element of the second directional coupler comprise winding parts passing through the PCB and wound at least one time to connect the ends of adjacent capacitance parts.

7. The substrate processing equipment of claim 6, wherein the winding parts comprise metal pattern parts formed on top and bottom surfaces of the PCB and vertical connection parts passing through the PCB in a vertical direction to electrically connect the metal pattern parts.

8. The substrate processing equipment of claim 6, wherein the voltage measurement unit comprises:
a capacitance part formed in a circumferential direction at a predetermined angle on at least one of an inner circumferential surface of the insertion part and top and bottom surfaces of an edge of the insertion part; and
a third output port part connected to the capacitance part.

9. The substrate processing equipment of claim 8, wherein at least one of a resistance element part and a third filter part is disposed between a first ground part and a branch point between the capacitance part and the third output port part.

10. The substrate processing equipment of claim 7, wherein the current measurement unit comprises:
an inductance part passing through the PCB in concentric with the voltage measurement unit further away from the voltage measurement unit based on the inner circumferential surface of the insertion part and winding at least one time; and
a fourth output port part connected to the inductance part.

11. The substrate processing equipment of claim 10, wherein at least one of a resistance element part and a fourth filter part is disposed between a second ground part and a branch point between the inductance part and the fourth output port part.

12. The substrate processing equipment of any one of claims 1 to 11, further comprising a plasma control unit connected to the grounding wire to control the plasma generated in the processing space using the current, voltage and power measured by the current, voltage and power measurement module.

13. The substrate processing equipment of claim 12, wherein the current, voltage and power measurement module and the plasma control unit are configured as a single module.

14. The substrate processing equipment of claim 13, wherein the plasma control unit is installed on the PCB of the current, voltage and power measurement module.

15. A current, voltage and power measurement module for a substrate processing equipment according to any one of claims 1 to 11, wherein a plasma control unit, which is connected to a heater power line and controls plasma generated in a processing space using current, voltage and power measured by the current, voltage and power measurement module, is configured as a single module with the current, voltage and power measurement module.
